# EUROPÄISCHE PATENTSCHRIFT

(11) **EP 3 027 472 B1**
(45) Veröffentlichungstag und Bekanntmachung des Hinweises auf die Patenterteilung: **03.01.2018**
(21) Anmeldenummer: 14734123.4
(22) Anmeldetag: 27.06.2014
(51) Int. Cl.: B60R 16/03, H02H 3/20, H02H 5/10, H02H 9/04, H02M 1/32, H02H 3/36, H02J 1/00, B60R 16/023, B60L 3/00, B60L 3/12, B60L 11/02, B60L 11/14, B60L 11/18, G01R 31/02, G01R 31/00

(54) **ÜBERSPANNUNGSSCHUTZ FÜR EIN MEHRSPANNUNGSBORDNETZ**
OVERVOLTAGE PROTECTION FOR A MULTI-VOLTAGE VEHICLE ELECTRICAL SYSTEM
PROTECTION CONTRE LES SURTENSIONS POUR UN RÉSEAU DE BORD À MULTIPLES TENSIONS

(30) Priorität: 30.07.2013 DE 102013214835
(43) Veröffentlichungstag der Anmeldung: 08.06.2016
(73) Patentinhaber: Robert Bosch GmbH, 70442 Stuttgart (DE)
(72) Erfinder: WALTER, Gerhard, 70839 Gerlingen (DE)
(86) Internationale Anmeldenummer: PCT/EP2014/063656
(87) Internationale Veröffentlichungsnummer: WO 2015/014551

(56) Entgegenhaltungen:
- EP-A1- 1 422 803
- EP-A2- 1 363 378
- WO-A1-2013/050207
- US-A1- 2004 130 214
- US-A1- 2009 015 973

## Beschreibung

Die vorliegende Erfindung betrifft eine Überspannungsschutzschaltung für ein Teilnetz eines Mehrspannungsbordnetzes, ein Mehrspannungsbordnetz mit einer solchen Überspannungsschutzschaltung sowie ein Verfahren zum Überspannungsschutz.

### Stand der Technik

In Kraftfahrzeugen gewinnen Bordnetze in Form von Mehrspannungsbordnetzen zunehmend an Bedeutung. Bordnetze können dabei einen elektrischen Generator ("Lichtmaschine"; üblicherweise ein Wechselstromgenerator, jedoch ist auch der Einsatz von Gleichstromgeneratoren bekannt) aufweisen, der die Bordspannung(en) für das Bordnetz durch Umwandlung mechanischer Bewegungsenergie in elektrische Energie bereitstellt.

Aufgrund immer höher werdenden elektrischen Energiebedarfs (durch bedarfsgerechte Elektrifizierung von bisher ungeregelten mechanisch oder hydraulisch betriebenen Verbrauchern) sowie durch die Intention, während Verzögerungsphasen eines Kraftfahrzeugs möglichst viel kinetische in elektrische Energie umzuwandeln, beginnt sich eine erhöhte Bordspannung (von insbesondere 48 V) zu etablieren. Mit einer derartigen Bordspannung, die gegenüber herkömmlichen geringeren Bordspannungen (12 V) eine ca. vierfach höhere Spannung aufweist, können im Vergleich zu herkömmlichen Bordspannungen einerseits vierfach geringere Ströme bzw. andererseits eine vierfach höhere Leistung erzielt werden. Eine obere Grenze der Bordspannung ist durch eine maximal zulässige Spannung von 60 V im Bordnetz gegeben, welche die Grenze zu (für Menschen) gefährlichen Berührungsspannungen darstellt, ab der (bei Überschreitung) aufwendige und teure Zusatzmaßnahmen notwendig werden (z.B. Warnhinweise, orange Kabel, doppelte Isolation, Isolationsüberwachungen,...).

Da in Kraftfahrzeugen eine Vielzahl an Verbrauchern vorhanden ist, die zum einen nicht einfach und kostengünstig auf eine höhere Bordspannung umstellbar sind und die zum anderen aus der höheren Bordspannung keinen technischen/monetären Vorteil ziehen können (z.B. Radio, Dashboard, Fensterheber,...), kann das Bordnetz als ein Mehrspannungsbordnetz, insbesondere als ein Zweispannungsbordnetz mit einem Niedervoltbordnetz mit einer ersten, niedrigeren Bordspannung (insbesondere 12 V bzw. 24 V) und mit einem Hochvoltbordnetz mit einer zweiten, höheren Bordspannung (48 V) ausgebildet werden.

Bei derartigen Mehrspannungsbordnetzen besteht die Gefahr eines unerwünschten Übersprechens aus dem Hochvoltbordnetz in das Niedervoltbordnetz, welches eine Zerstörung aller Niedervoltkomponenten (die i.d.R. eine maximale Spannungsfestigkeit von max. 34 V/500 ms haben) nach sich ziehen könnte.

Eine Möglichkeit, ein Übersprechen zu verhindern, ist das Bereitstellen von galvanisch getrennten Masseleitungen des 48V-Bordnetzes (KL.41) und des 12V-Bordnetzes (KL.31), um bei Masseunterbrechungen eine mögliche Verkopplung bzw. weiterführende Zerstörungen sicher auszuschließen. Eine galvanische Trennung kann auf kapazitivem Wege (z.B. spezielle ISO-Bausteine), optischem Wege (z.B. Optokoppler) oder aber induktivem Wege (z.B. HF-Trafos) erfolgen. Allen diesen Methoden ist im automotiven Umfeld gemeinsam, dass sie aufwendig und teuer sind (u.a. wegen hohen Anforderungen an Lebensdauer und Temperaturbereich sowie kleinen Stückzahlen).

Der Platzbedarf sowie die Erhöhung der Komplexität sind ebenso nicht unerheblich. Andererseits bieten die o.g. galvanischen Trenner i.d.R. Spannungsfestigkeiten weit über die geforderten 60V hinaus (i.d.R. bis 1.000Voder 1.200V), da sie heute hauptsächlich für 230VAC (Netz) bzw. 400V bzw. 600VAC (Hybrid) eingesetzt werden. Sie sind also deutlich überdimensioniert und entsprechend teuer.

Ein Umsetzen der Forderung nach getrennten Masseleitungen würde (zusätzlich zu den Nachteilen durch den Aufwand zur galvanischen Trennung) bei der Generatoranwendung (Hochvoltgenerator, z.B. Boost Rekuperations Maschine BRM) dazu führen, dass (entgegen dem Stand der Technik bei Kfz-Generatoren) nicht mehr die Motormasse (über die Befestigungsschrauben) als Masse verwendet werden dürfte bzw. könnte, sondern stattdessen mit entsprechendem Aufwand gegenüber dem Motorblock isoliert werden müsste. Dies ist insbesondere hinsichtlich der Kosten und Robustheit besonders nachteilig. Weiterhin müsste ein eigener Masseanschlussbolzen am Generator geschaffen werden, was neben den zusätzliche Kosten und Bauraumproblemen prinzipbedingt die Gefahr von Verpolungen birgt. Auch müsste dieser eigene Masseanschlussbolzen separat mit der Karosseriemasse verbunden werden, wozu ein entsprechend stromfestes (und daher dickes und teures) Masseband notwendig wäre. Die zu erwartende Länge des Massebandes würde wiederum EMV-Maßnahmen (z.B. Common-Mode-Filter) erforderlich machen. Bei den hohen Leistungen (hohen Strömen), die das Bereitstellen eines 48V-Bordnetz erst nötig bzw. sinnvoll machen (beim BRM z.B. 250A-300A), ergeben sich an dem Common-Mode-Filter relevante Spannungsabfälle (Verlustleistungen), die den Wirkungsgradgewinn verringern (= Performanceverlust).

Es ist daher wünschenswert, den Motorblock als gemeinsamen Massenanschluss erhalten zu können, wobei die elektrische Maschine zur Versorgung des Hochvoltbordnetzes mit Masse am Motorblock befestigt ist, welcher ebenfalls das Massepotential für das Niedervoltbordnetz definiert. Im Falle eines sog. Masseabrisses (Abbruch der Masseverbindung zwischen dem Motorblock und der Karosserie, welche ein Referenzmassepotential definiert) kommt es nun aber ohne weitere Maßnahmen zu einer Überspannung im Niedervoltbordnetz.

Es ist daher wünschenswert eine Möglichkeit bereitzustellen, um ein unerwünschtes Übersprechen aus einem Hochvoltbordnetz in ein Niedervoltbordnetz eines Mehrspannungsbordnetzes zu verhindern.

Ferner ist in WO 2013/050207 A1 eine Schutz- und/oder Diagnose-Einrichtung für ein Mehrspannungsbordnetz eines Kraftfahrzeugs offenbart, wobei das Mehrspannungsbordnetz ein erstes Teilnetz, das mit einer ersten Spannung beaufschlagbar ist, und wenigstens ein weiteres Teilnetz, das mit wenigstens einer weiteren Spannung beaufschlagbar ist, aufweist, wobei die erste Spannung höher als die wenigstens eine weitere Spannung ist.
US 2009/015973 A1 offenbart eine Fehlerstromschutzschaltung, die vorzugsweise in einem Fahrzeugbordnetz, insbesondere einem Mehrspannungsbordnetz, hochspannungsseitig eingebaut ist und ohne Strommessung arbeitet.
US 2004/130214 A1 offenbart ein Zweispannungsbordnetz, umfassend einen Generator zum Erzeugen einer ersten Nennspannung auf einem ersten Spannungsbus zu einem bidirektionalen DC/DC-Wandler, um die erste Sollspannung auf eine zweite Nennspannung auf einem zweiten Spannungsbus zu wandeln.
EP 1363378 A2 offenbart ein Verfahren und eine Vorrichtung zur Kurzschlusserkennung und zum Überspannungsschutz zwischen Spannungsebenen in zwei Spannungsbordnetzen, die ein unterschiedliches Spannungsniveau aufweisen, wobei in mindestens einem Zweig des Bordnetzes auf dem höheren Spannungsniveau ein Schaltelement angeordnet ist, und im Bordnetz auf dem niedrigerem Spannungsniveau mindestens eine Messeinrichtung angeordnet ist, in deren Abhängigkeit das Schaltelement schaltbar ist, wobei mittels der Messeinrichtung der in die Verbraucherzweige fließenden Strom vorzeichengerecht erfassbar ist.

### Offenbarung der Erfindung

Erfindungsgemäß werden eine Überspannungsschutzschaltung, ein Mehrspannungsbordnetz mit einer solchen Überspannungsschutzschaltung sowie ein Verfahren zum Überspannungsschutz mit den Merkmalen der unabhängigen Patentansprüche vorgeschlagen. Vorteilhafte Ausgestaltungen sind Gegenstand der Unteransprüche sowie der nachfolgenden Beschreibung.

Das Mehrspannungsbordnetz weist ein erstes Teilnetz mit einer ersten Bordspannung, ein zweites Teilnetz mit einer zweiten Bordspannung und eine elektrische Maschine zum Versorgen des zweiten Teilnetzes auf, wobei die erste Bordspannung geringer als die zweite Bordspannung ist.

Das erste Teilnetz, das zweite Teilnetz und die elektrische Maschine sind an einem gemeinsamen ersten Masseanschluss angeschlossen, der auf einem gemeinsamen Massepotential liegt. Dieser erste Masseanschluss ist dabei insbesondere als Motorblock bzw. Motormasse realisiert. Die elektrische Maschine ist dabei insbesondere über mechanische Verschraubungspunkte galvanisch mit dem Motorblock verbunden. Dadurch wird eine sehr niederimpedante, zuverlässige und kostengünstige Masseanbindung realisiert. Eine erfindungsgemäße Überspannungsschutzschaltung weist einen zweiten Masseanschluss zum Anschließen eines Referenzmassepotentials, insbesondere der Karosseriemasse, auf. Erfindungsgemäß überprüft die Überspannungsschutzschaltung, ob eine Massedifferenzspannung zwischen dem ersten Masseanschluss und dem zweiten Masseanschluss einen Schwellwert erreicht. Im Fall einer Masseunterbrechung (z.B. Massebandabriss) zwischen dem gemeinsamen Massepotential und dem Referenzmassepotential steigt die Massedifferenzspannung an. Der Schwellwert wird daher insbesondere als ein maximal zulässiger oberer Grenzwert für die Massedifferenzspannung gewählt. Erreicht die Massedifferenzspannung den Schwellwert, werden Überspannungsschutzmaßnahmen durchgeführt, um die Massedifferenzspannung und damit die erste Bordspannung zu begrenzen.

### Vorteile der Erfindung

Durch die erfindungsgemäße Überspannungsschutzschaltung wird frühzeitig eine zu hohe Massedifferenzspannung, insbesondere in Folge einer Leitungsunterbrechung zwischen Bezugsmassepotential und Referenzmassepotential, erkannt. Die Komponenten des ersten Teilnetzes werden somit durch die entsprechenden Überspannungsschutzmaßnahmen vor Überspannung geschützt. Ein Übersprechen aus dem zweiten Teilnetz (Hochvoltbordnetz) in das erste Teilnetz (Niedervoltbordnetz) und eine damit verbundene Zerstörung von Komponenten der Teilnetze wird verhindert. Dies wird in besonders vorteilhafter und einfacher Weise auch für den Fall erreicht, dass die Masseleitungen des Hochvoltnetzes und des Niedervoltnetzes nicht am Motorblock galvanisch getrennt sind, so dass weiterhin nur ein Masseband zwischen Motorblock und Karosserie ausreicht. Die oben erläuterten, mit einer galvanischen Trennung der Massen und mit zwei Massebändern verknüpften Nachteile werden vermieden.

Mittels der Erfindung wird eine kontinuierliche Überwachung des Bezugsmassepotentials durchgeführt. Im Fehlerfall (Auftreten einer Überspannung) wird zum einen die elektrische Maschine selbst vor zerstörerischen Überspannungen (oder auch Unterspannungen) geschützt und zum anderen wird sichergestellt, dass an dem gemeinsamen ersten Masseanschluss direkt angeschlossene elektrische Verbraucher (wie z.B. Glühkerzen sowie deren Ansteuergeräte) sowie das mittelbar über die direkt angeschlossenen elektrischen Verbraucher angeschlossene erste Teilnetz nicht beschädigt werden.

Die Überspannungsschutzmaßnahmen können aktive und/oder passive Maßnahmen umfassen. Passive Maßnahmen können dabei insbesondere von speziellen Komponenten der Überspannungsschutzschaltung realisiert werden. Aktive Maßnahmen können beispielsweise Steuerungsmaßnahmen sein. Insbesondere werden die Überspannungsschutzmaßnahmen (wie weiter unten beschrieben) in drei unterschiedlichen Stufen realisiert, welche durch vorteilhafte Ausgestaltungen der erfindungsgemäßen Überspannungsschutzschaltung realisiert werden.

Mittels des zusätzlichen zweiten Masseanschlusses wird insbesondere eine Masseleitung zu einem Karosseriepunkt des Kraftfahrzeugs realisiert. Der zweite Masseanschluss befindet sich vorzugsweise in einem Signalstecker, in welchem auch Kommunikationsleitungen, insbesondere in Form eines CAN-Bussystems, angesteckt werden. Die Erfindung kann daher ohne besonderen Verkabelungsaufwand auch in bestehende Mehrspannungsbordnetze implementiert werden, da Kommunikationsleitungen meist ohnehin über Masseleitungen, beispielsweise zur Schirmung, verfügen.

Vorteilhafterweise weist die Überspannungsschutzschaltung ein passives Schutzelement auf, welches zwischen den ersten und den zweiten Masseanschluss geschaltet ist. Dieses passive Schutzelement kann insbesondere Zenerdioden, insbesondere zwei Zenerdioden in einer bipolare Zenerstruktur, und/oder MOSFETs (Metall-Oxid-Halbleiter-Feldeffekttransistor), insbesondere zwei in Reihe geschaltete MOSFETs, umfassen. Das passive Schutzelement ist insbesondere Teil der passiven Maßnahmen der Überspannungsschutzmaßnahme und bildet eine erste Stufe der Überspannungsschutzmaßnahme. Durch das passive Schutzelement wird ein übermäßiger Spannungsanstieg schon verhindert, bevor aktive Maßnahmen greifen können. Eine bipolare Anordnung zweier Zenerdioden ermöglicht dabei besonders einfach eine Begrenzung der entsprechenden Spannung.

Das passive Schutzelement übernimmt den Überspannungsschutz bzw. die Überspannungsschutzmaßnahmen sofort nach Auftreten der Überspannung insbesondere solange, bis aktive Maßnahmen eingeleitet werden können. Dies umfasst insbesondere ein Zeitintervall zwischen 10 µs und 100 µs nach dem Masseabriss bzw. nach Auftreten der Überspannung. Nach diesem Zeitintervall wird der Masseabriss detektiert und aktive Maßnahmen, insbesondere Steuermaßnahmen werden eingeleitet. Dies erfolgt insbesondere in einer zweiten Stufe der Überspannungsschutzmaßnahmen.

Eine Ansteuerung der MOSFETs erfolgt zweckmäßig mittels einer Beschaltung aus temperaturentkoppelten und temperaturstabilisierten Zenerdioden und Diodenketten. Somit wird eine kleine Toleranz der Zenerdioden und einer Thresholdspannung der MOSFETs sowie eine stabilisierte Temperaturabhängigkeit gewährleistet. Alternativ oder zusätzlich kann eine Beschaltung aus einer separaten Spannungsregelung mit geringem Hardwareaufwand realisiert werden.

Dadurch werden Initialtoleranzen und Temperaturabhängigkeiten der MOSFETs über die separaten Spannungsregelung ausgeglichen.

Das passive Schutzelement kann beispielsweise auch als eine Reihenschaltung wenigstens einer Zenerdiode mit wenigstens einer Halbleiterdiode, durch eine TVS-Diode (Transient-Voltage-Supression), wenigstens einen mittels einer Zenerdiode gesteuerten FET (Feldeffektransistor) oder durch wenigstens einen Varistor ausgebildet sein.
Vorzugsweise weist die Überspannungsschutzschaltung einen Komparator auf, der eingangsseitig mit dem ersten Masseanschluss und mit dem zweiten Masseanschluss verbunden ist. Der Komparator bestimmt dabei die Massedifferenzspannung zwischen dem ersten Masseanschluss und dem zweiten Masseanschluss und vergleicht die Massedifferenzspannung mit dem Schwellwert. Der Komparator erkennt dabei einen schnellen (hochenergetischen) Spannungssprung zwischen den beiden Masseanschlüssen. Überschreitet die Massedifferenzspannung den Schwellwert, alarmiert der Komparator insbesondere einen Mikrocontroller bzw. ein Steuergerät. Dabei sendet der Komparator insbesondere ein digitales Signal aus. Der Komparator triggert dabei einen digitalen Interrupt an dem Mikrocontroller bzw. Steuergerät. Der Mikrocontroller bzw. das Steuergerät führt daraufhin mehrere zweckmäßige Messungen durch, um den Masseabriss zu plausibilisieren. Der Mikrocontroller bzw. das Steuergerät detektiert somit den Masseabriss und leitet die aktiven Maßnahmen der Überspannungsschutzmaßnahme ein. Diese Detektion des Masseabriss und das Einleiten der aktiven Maßnahmen stellt insbesondere die zweite Stufe der Überspannungsschutzmaßnahme dar.
Weist die Überspannungsschutzschaltung keinen Komparator auf, kann der Mikrocontroller bzw. das Steuergerät auch mittels eines analogen Signals alarmiert bzw. getriggert werden. Über einen analogen Eingang am Mikrocontroller bzw. Steuergerät wird dabei in regelmäßigen Abständen (z.B. 1ms) die Massedifferenzspannung von der Überspannungsschutzschaltung abgefragt. Um hier nicht auf einen Einzelimpuls zu reagieren, sollten mindestens drei oder mehrere Werte der Massedifferenzspannung abgefragt werden. Damit ist eine sehr langsame Reaktionszeit verbunden, bis der Mikrocontroller bzw. das Steuergerät Überspannungsschutzmaßnahmen einleiten kann bzw. bis die Überspannung detektiert wird. Das passive Schutzelement bildet währenddessen die Überspannungsschutzmaßnahme und erwärmt sich dabei um eine bestimmte Temperatur. Dieses Prinzip eignet sich insbesondere bei einem langsamen, "schleichenden" Abriss des gemeinsamen Massenschlusses.

Driftet die Spannung zwischen dem ersten Massenschluss und dem zweiten Masseanschluss nur langsam auseinander, liegt kein "harter" Abriss des ersten Massenschlusses vor, sondern ein "schleichender" verschleißbedingter Abriss des ersten Massenschlusses. Dies kann beispielsweise durch Korrosion z.B. einer Schraube bzw. der Motormasse der Fall sein. Dieser Fall kann beispielsweise über zyklische langsame AD-Messungen (z.B. im Predrive) erkannt werden. In diesem Fall wird ebenfalls die Überspannungsschutzmaßnahme durchgeführt. Wird ein charakteristischer Spannungsversatz, der auf einen derartigen verschleißbedingter Abriss des ersten Massenschlusses insbesondere durch Korrosion hindeutet, erkannt, kann bei entsprechender Höhe des Versatzes der Betrieb vor dem Hochfahren des Systems unterbunden werden.

Bevorzugt werden als Überspannungsschutzmaßnahme bzw. als aktive Maßnahmen elektrische Verbraucher in dem zweiten Teilnetz zum Spannungsabbau eingeschaltet. Alternativ oder zusätzlich wird bevorzugt als Überspannungsschutzmaßnahme zweckmäßig zwischen einem motorischen und einem generatorischen Betrieb der elektrischen Maschine gewechselt. Alternativ oder zusätzlich wird bevorzugt ein (rollierender) Phasenkurzschluss von Phasenanschlüssen der elektrischen Maschine durchgeführt. Rollierend bedeutet, dass die kurzzuschließende Phase durchgewechselt wird. Somit wird eine Regelung auf einen definierten (geringen) Masseversatz ermöglicht, bis die verbleibende Energie aus dem System genommen ist und das System stromlos passiviert ist.

Der Wechsel zwischen motorischem und generatorischem Betrieb der elektrischen Maschine wird insbesondere durch eine Phasenwinkelverschiebung durchgeführt. Dadurch kann elektrische Energie im motorischen Betrieb verbraucht und so dem Bordnetz entzogen werden. Der Phasenwinkel entspricht dabei einer Phasenverschiebung zwischen Phasenspannung und Polradspannung der elektrischen Maschine. Die Phasenspannung ist dabei eine Spannung, die an eine Statorwicklung eines Stators der elektrischen Maschine angelegt wird. Die Polradspannung entspricht einer Spannung, die von einem Erregerstrom durch eine Läuferwicklung eines Läufers in der Statorwicklung induziert wird. Im generatorischen Betrieb der elektrischen Maschine nimmt der Phasenwinkel positive Werte an, im motorischen Betrieb der elektrischen Maschine negative Werte. Der Phasenwinkel wird mittels der Vorgabe der Phasenspannung (durch den Stromrichter zwischen Stator und Bordnetz) verstellt.

Bei einem bestimmten (von der Bauart abhängigen) Phasenwinkel wird die elektrische Maschine weder im generatorischen noch im motorischen Betrieb betrieben. Die von der elektrischen Maschine verbrauchte elektrische Leistung wird als Verlustleistung in der elektrischen Maschine oder zusätzlich der Leistungsendstufe verbraucht. So kann auch während eines längeren Zeitintervalls die elektrische Maschine als elektrischer Verbraucher genutzt werden, um die durch Überspannung in das Bordnetz eingebrachte elektrische Energie zu verbrauchen und die erste Bordspannung so zu verringern.

Andererseits kann der Phasenwinkel kontinuierlich verstellt werden, wobei die elektrische Maschine kontinuierlich vom generatorischen in den motorischen Betrieb (und umgekehrt) überführt wird. Dabei erfolgt eine kontinuierliche Stromabgabe bzw. Stromaufnahme. Der Generatorstrom kann somit auf den maximal zulässigen Spannungswert des ersten Bordnetzes eingestellt werden. Dieser Vorgang kann gesteuert oder auch geregelt (auf z.B. Masseversatzspannung) erfolgen. Die elektrische Maschine kann dabei mittels Erzeugen eines Drehmomentes die im Bordnetz überschüssige elektrische Energie verbrauchen.

In einer vorteilhaften Ausgestaltung der Erfindung wird als Überspannungsschutzmaßnahme bzw. als aktive Maßnahmen eine Verbindung zwischen dem zweiten Teilnetz und der elektrischen Maschine getrennt. Dies stellt die dritte Stufe der Überspannungsschutzmaßnahme dar. Das zweite Teilnetz wird somit abgeschaltet und leistungslos geschaltet. Eine mögliche Gefährdung durch eine Überspannung der Komponenten des ersten und des zweiten Teilnetzes ist nicht mehr gegeben. Ein Energienachschub aus dem zweiten Teilnetz (beispielsweise einer Hochvoltbatterie des zweiten Teilnetzes und/oder einer Energieübertragung eines DCDC-Wandlers) wird insbesondere auf Null reduziert.

Energiefluss von der elektrischen Maschine in das zweite Teilnetz wird unterbrochen, z.B. durch Öffnen der Hauptschütze eines Energiespeichers des zweiten Teilnetzes und/oder durch Abregelung der Energieübertragung des DCDC-Wandlers aus dem ersten Teilnetz. Zusätzlich werden wenn möglich elektrische Verbraucher zum Abbau der Energie im ersten Teilnetz eingeschaltet (Zeitdauer ca. 20ms bis 50ms).

Diese dritte Stufe der Überspannungsschutzmaßnahme wird ebenfalls durch den Mikrocontroller bzw. das Steuergerät eingeleitet, insbesondere über das Kommunikationsnetz bzw. das CAN-Bussystem. Diese dritte Stufe der Überspannungsschutzmaßnahme ist auf ein längeres Zeitintervall ausgelegt, da das CAN-Bussystem üblicherweise Reaktionszeiten um die 10 ms aufweist und in Batterien häufig mechanische Relais (mit Auslösezeiten zwischen 10 ms und 100 ms) verbaut sind. Somit wird eine Dauerfestigkeit gegen Überspannungen gewährleistet (da das passive Schutzelement über ein derart langes Zeitintervall gegebenenfalls überlastet wäre).

Zusätzlich kann ein Fehlereintrag in einem Steuergerät des Energiespeichers des zweiten Teilnetzes bzw. der Hochvoltbatterie oder der anderen Komponenten des zweiten Teilnetzes (z.B. DC/DC-Wandler, elektrische Lenkung) erstellt werden. Dies ermöglicht eine Diagnosefähigkeit.

Bevorzugt wird eine Warnung bzw. ein Warnsignal an Komponenten des zweiten Teilnetzes ausgegeben, insbesondere über das CAN-Bussystem, bevor die Überspannungsschutzmaßnahme durchgeführt wird. Die Warnung wird dabei insbesondere an alle im zweiten Teilnetz vorhandenen Steuergeräte für Energiequellen (z.B. Energiespeicher, DC/DC-Wandler, elektrische Lenkung) ausgegeben. Insbesondere wird dabei als Warnung ausgegeben, dass ein Energiefluss in das zweite Teilnetz unterbrochen wird (z.B. durch Öffnen der Hauptschütze des Energiespeichers oder Abregelung der Energieübertragung des DC/DC-Wandlers) und/oder elektrische Verbraucher des zweiten Teilnetzes zum Spannungsabbau eingeschaltet werden.

Eine erfindungsgemäße Recheneinheit, z.B. ein Steuergerät eines Kraftfahrzeugs, ist, insbesondere programmtechnisch, dazu eingerichtet, ein erfindungsgemäßes Verfahren durchzuführen.

Auch die Implementierung des Verfahrens in Form von Software ist vorteilhaft, da dies besonders geringe Kosten verursacht, insbesondere wenn ein ausführendes Steuergerät noch für weitere Aufgaben genutzt wird und daher ohnehin vorhanden ist. Geeignete Datenträger zur Bereitstellung des Computerprogramms sind insbesondere Flash-Speicher, EEPROMs u.a.m. Auch ein Download eines Programms über Computernetze (Internet, Intranet usw.) ist möglich.

Weitere Vorteile und Ausgestaltungen der Erfindung ergeben sich aus der Beschreibung und der beiliegenden Zeichnung.

Es versteht sich, dass die vorstehend genannten und die nachfolgend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand von Ausführungsbeispielen in der Zeichnung schematisch dargestellt und wird im Folgenden unter Bezugnahme auf die Zeichnung ausführlich beschrieben.

Kurze Beschreibung der Zeichnungen
- Figur 1: zeigt ein Zweispannungsbordnetz mit einer erfindungsgemäßen Überspannungsschutzschaltung gemäß einer bevorzugten Ausführungsform der Erfindung in schematischer Darstellung.
- Figur 2: zeigt eine bevorzugte Ausführungsform einer erfindungsgemäßen Überspannungsschutzschaltung in schematischer Darstellung.
- Figur 3: zeigt eine bevorzugte Ausführungsform eines erfindungsgemäßen Verfahrens als ein Blockdiagramm.

### Ausführungsform(en) der Erfindung

Die Figuren werden im Folgenden zumindest teilweise zusammenhängend beschrieben. Gleiche Bezugszeichen in den unterschiedlichen Figuren beziehen sich auf identische Bauteile.

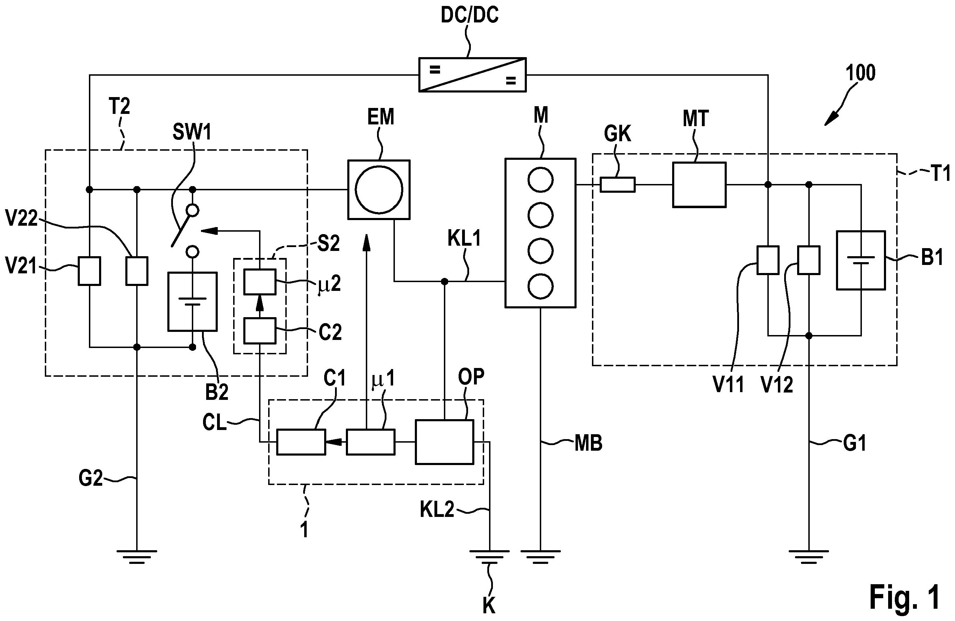

In Figur 1 ist ein Mehrspannungsbordnetz in Form eines Zweispannungsbordnetzes gemäß einer bevorzugten Ausführungsform der Erfindung schematisch dargestellt und insgesamt mit 100 bezeichnet. Das Zweispannungsbordnetz 100 weist ein erstes Teilnetz T1 und ein zweites Teilnetz T2 auf. Das erste Teilnetz T1 besitzt dabei eine geringere erste Bordspannung von insbesondere 12 V oder 24 V, das zweite Teilnetz T2 besitzt eine höhere zweite Bordspannung von insbesondere 48 V.

Das erste Teilnetz T1 weist einen ersten Energiespeicher B1, beispielsweise einen Lithium-Ionen-Akkumulator, einen kapazitiven Speicher oder eine herkömmliche Fahrzeugbatterie, auf. Der erste Energiespeicher B1 stellt beispielsweise die erste Bordspannung von +12 V bereit. In dem ersten Teilnetz T1 sind durch ein vereinfachtes Ersatzschaltbild symbolisiert ein erster elektrischer Verbraucher V11 und ein zweiter elektrischer Verbraucher V12 angeordnet.

Das erste Teilnetz T1 weist weiterhin ein Steuergerät in Form eines Motorsteuergeräts MT auf. Das Motorsteuergerät MT steuert beispielsweise Glühkerzen GK einer Brennkraftmaschine M an.

Mit der Brennkraftmaschine M ist eine elektrische Maschine EM zur Versorgung des zweiten Teilnetzes T2 verbunden, die beispielsweise als ein Klauenpolgenerator ausgebildet ist und sowohl generatorisch als auch als motorisch betrieben werden kann. Die elektrische Maschine EM ist über ihr Gehäuse mit einem Motorblock der Brennkraftmaschine M elektrisch leitend, in Figur 1 mit KL1 bezeichnet, verbunden. Der Motorblock der Brennkraftmaschine M dient als Masse für die elektrische Maschine EM und damit zugleich auch für das zweite Teilnetz T2. Üblicherweise bildet auch die Verschraubung der Glühkerzen mit dem Motorblock gleichzeitig den Masseanschluss, so dass dadurch ein gemeinsamer Masseanschluss gebildet wird.

Die elektrische Maschine EM ist mit dem zweiten Teilnetz T2 verbunden. Über einen Gleichspannungswandler DC/DC ist das erste Teilnetz T1 mit dem zweiten Teilnetz T2 gekoppelt.

Die elektrischen Verbraucher V11 und V12 sowie das Motorsteuergerät MT und die Glühkerzen GK stellen Komponenten (Niedervoltkomponenten) des ersten Teilnetzes T1 dar und besitzen eine Spannungsfestigkeit von beispielsweise max. 34 V/500 ms.

Das zweite Teilnetz T2 umfasst ebenfalls einen Energiespeicher B2, der über einen Schalter SW1 mit dem zweiten Teilnetz T2 verbunden ist, und elektrische Verbraucher V21 und V22, welche Komponenten (Hochvoltkomponenten) des zweiten Teilnetzes T2 darstellen. Der Energiespeicher B2 kann wie der oben erläuterte Energiespeicher B1 ausgebildet sein und liefert die zweite Bordspannung von +48 V.

Der Energiespeicher B1 des ersten Teilnetzes T1 ist an einem Masseanschluss G1 angeschlossen. Der Energiespeicher B2 des zweiten Teilnetzes T2 ist an einem Masseanschluss G2 angeschlossen. Bei den Masseanschlüssen G1 und G2 handelt es sich um Masseanschlüsse auf einem Referenzpotential, hier beispielsweise Karosseriepotential.

Als weitere Bezugsmasse für das Zweispannungsbordnetz dient der Motorblock der Brennkraftmaschine M, der einen gemeinsamen Masseanschluss für das erste Teilnetz T1, die elektrische Maschine EM und für das zweite Teilnetz T2 darstellt. Der Motorblock ist über ein Masseband MB mit der Referenzmasse verbunden.

Bei einem Abriss des Massebands MB kommt es zu einem Auseinanderdriften der beiden Massepotentiale und damit zu einer Überspannung in dem ersten Teilnetz T1. Erfolgt ein derartiger Masseabriss, fließt ein Fehlerstrom, aufgrund dessen die in dem ersten Teilnetz T1 angeordneten Glühkerzen GK und das Motorsteuergerät MT verpolt und mit einer entsprechenden Verpolungsspannung bzw. Überspannung beaufschlagt werden. Die Überspannung besitzt dabei zumeist einen Spannungswert, welcher die maximale Spannungsfestigkeit des Motorsteuergeräts MT üblicherweise überschreitet und dieses zerstört. Dadurch kann es zu einem Durchschlagen der Überspannung in das zweite Teilnetz T2 und zu einer Zerstörung der Niedervoltkomponenten V11 und V12 kommen.
Um die Komponenten MT, V11 und V12 des ersten Teilnetzes T1 vor Überspannung zu schützen und ein Zerstören der Komponenten MT, V11 und V12 des ersten Teilnetzes T1 zu verhindern, weist das Zweispannungsbordnetz 100 weiterhin eine bevorzugte Ausführungsform einer erfindungsgemäßen Überspannungsschutzschaltung 1 auf.
Die Überspannungsschutzschaltung 1 ist eingangsseitig mit der elektrische Maschine EM bzw. mit dem Masseanschluss KL1 der elektrischen Maschine EM verbunden. Die Überspannungsschutzschaltung 1 weist einen zusätzlichen zweiten Masseanschluss KL2 (z.B. eine Signalmasseleitung) auf. Dieser zweite Masseanschluss KL2 ist mit dem Referenzmassepotential verbunden. Eine Komparatorschaltung OP der Überspannungsschutzschaltung 1 überprüft, ob eine Massedifferenzspannung zwischen dem ersten Masseanschluss KL1 und dem zweiten Masseanschluss KL2 einen Schwellwert erreicht.
Die Komparatorschaltung OP ist mit einem ersten Mikrocontroller µ1 verbunden. Der Mikrocontroller µ1 ist programmtechnisch zur Durchführung eines erfindungsgemäßen Verfahrens eingerichtet und kann dazu insbesondere die elektrische Maschine EM steuern und/oder Steuerbefehle über einen ersten CAN-Sender/Empfänger C1, welcher mit einer eine Kommunikationsleitung CL bzw. mit einem CAN-Bus verbunden ist, ausgeben.

Über den CAN-Bus CL kann die Überspannungsschutzschaltung 1 mit einem Steuergerät S2 in dem zweiten Teilnetz T2 kommunizieren. Auch unterschiedliche der Verbraucher V21, V22 sind an der Kommunikationsleitung CL angeschlossen.

Das Steuergerät S2 weist ebenfalls einen CAN-Sender/Empfänger C2 und einen Mikrocontroller µ2 auf. Das zweite Steuergerät S2 ist beispielsweise ein Steuergerät des zweiten Energiespeichers B2 (Batterie-Management-System BMS) oder ein Steuergerät des zweiten Teilnetzes T2.

Die CAN-Sender/Empfänger C1 und C2 müssen nicht notwendigerweise gesonderte Bauteile sein, sondern können insbesondere als ein Teil des jeweiligen Mikrocontrollers µ1 bzw. µ2 ausgebildet sein.

Ausgangsseitig ist die Überspannungsschutzschaltung 1 letztendlich mit dem zweiten Teilnetz T2 verbunden und steht somit in Wirkverbindung mit dem Mikrocontroller µ2.

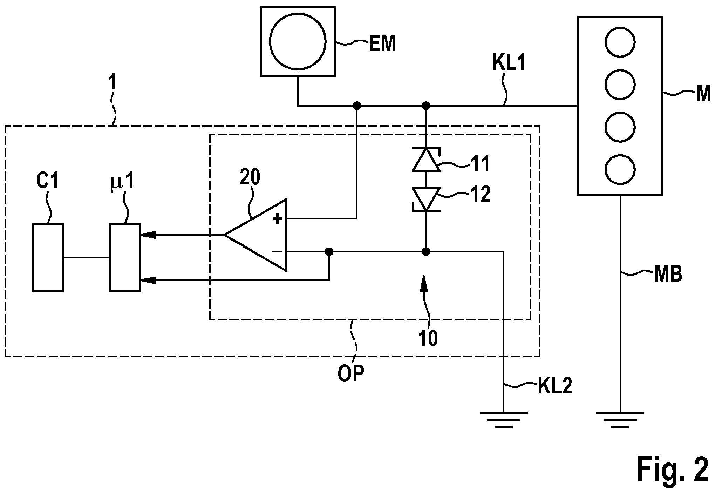

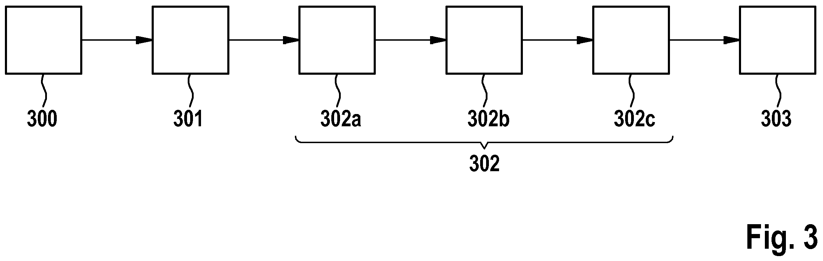

Eine bevorzugte Ausführungsform der erfindungsgemäßen Überspannungsschutzschaltung 1 ist in Figur 2 schematisch dargestellt. Das Zweispannungsbordnetz 100 ist des Weiteren dazu eingerichtet, eine bevorzugte Ausführungsform eines erfindungsgemäßen Verfahrens zum Überspannungsschutz durchzuführen. Selbige ist in Figur 3 schematisch als ein Blockdiagramm dargestellt.

Aufbau und Funktionsweise der erfindungsgemäßen Überspannungsschutzschaltung 1 sowie der Ablauf des erfindungsgemäßen Verfahrens werden im Folgenden anhand von Figur 2 und 3 zusammenhängend erläutert.

Um zu überprüfen, ob die Massedifferenzspannung den Schwellwert erreicht, weist die Überspannungsschutzschaltung 1 die Komparatorschaltung OP mit einem Komparatorbauteil (z.B. Operationsverstärker) 20 auf. Das Komparatorbauteil ist eingangsseitig über KL1 mit dem Bezugsmassepotential des Motorblocks und über KL2 mit dem Referenzmassepotential der Karosserie verbunden und vergleicht die Massedifferenzspannung mit dem Schwellwert. Solange das Masseband MB eine galvanische Verbindung zwischen dem Motorblock M und der Karosserie herstellt, sind die beiden Massepotentiale im Wesentlichen gleich und die Massedifferenzspannung somit im Wesentlichen Null. Ist jedoch die galvanische Verbindung beeinträchtigt oder beschädigt, steigt die Massedifferenzspannung an.

Erreicht die Massedifferenzspannung einen vorgegebenen Schwellwert, kann dies durch den Mikrocontroller µ1 detektiert werden, der dann einen Fehlerfall erkennt und Überspannungsschutzmaßnahmen einleitet. Da diese (aktive) Detektion allerdings ein Zeitintervall von bis zu 100 µs nach dem Auftreten der Überspannung in Anspruch nehmen kann, weist die Überspannungsschutzschaltung 1 zusätzlich ein passives Schutzelement 10 auf, welches innerhalb dieses Zeitintervalls als eine erste Stufe der Überspannungsschutzmaßnahme den Überspannungsschutz des Zweispannungsbordnetzes 100 übernimmt.

In Figur 3 tritt dabei in einem Schritt 300 besagter Fehlerfall in Form einer Unterbrechung des Massebands MB (Masseabriss) auf. In Schritt 301 wird diese erste Stufe der Überspannungsschutzmaßnahme durch das passive Schutzelement 10 der Überspannungsschutzschaltung 1 realisiert. Das passive Schutzelement 10 weist dabei zwei Zenerdioden 11 und 12 auf, die in einer bipolaren Zenerstruktur angeordnet sind und zwischen den ersten Masseanschluss KL1 und den zweiten Masseanschluss KL2 geschaltet sind. Das passive Schutzelement 10 übernimmt eine passive Überspannungsschutzmaßnahme, bis aktive Überspannungsschutzmaßnahmen eingeleitet werden. Das passive Schutzelement 10 begrenzt die Massendifferenzspannung.

In Schritt 302a bestimmt das Komparatorbauteil 20, wie oben erläutert, dass die Massedifferenzspannung den Schwellwert erreicht. Dies wird vom Mikrocontroller µ1 detektiert, der anschließend zweckmäßigerweise mehrere Messungen durchführt, um den Masseabriss zu plausibilisieren. Ergeben die Messungen ebenfalls, dass eine Überspannung vorliegt, wird somit der Fehlerfall detektiert. Die Überspannungsschutzschaltung 1 bzw. der Mikrocontroller µ1 leitet nun aktive Überspannungsschutzmaßnahmen ein.

Eine erste aktive Überspannungsschutzmaßnahme beinhaltet in Schritt 302b eine Reduktion der von der elektrischen Maschine EM erzeugten Spannung. Dazu wird die elektrische Maschine EM von der Überspannungsschutzschaltung 1 so angesteuert, dass die Bordspannung im zweiten Teilnetz T2 und dadurch ein Übersprechen vom zweiten Teilnetz T2 in das erste Teilnetz T1 reduziert wird. Die Überspannungsschutzschaltung 1 führt dabei insbesondere eine Phasenwinkelverschiebung der elektrischen Maschine EM durch, wodurch kontinuierlich die von der elektrischen Maschine erzeugte Leistung (generatorischer Betrieb) reduziert und bis hin zu einer Leistungsaufnahme (motorischer Betrieb) verstellt werden kann. Alternativ oder zusätzlich kann die von der elektrischen Maschine EM erzeugte Spannung reduziert werden, indem ein Erregerfeld reduziert wird, insbesondere im Wege einer Schnellentregung. Mit beiden Maßnahmen wird versucht, die Massedifferenzspannung unter dem Schwellwert zu halten, z.B. auf einem bestimmten Wert oder auf Null.

Vorzugsweise sendet die Überspannungsschutzschaltung 1 in Schritt 302c auch über den CAN-Sender/Empfänger C1 und die Kommunikationsleitung CL ein digitales Signal aus, welches alle über die Kommunikationsleitung CL erreichbaren Verbraucher V21, V22 im zweiten Teilnetz T2 anweist, möglichst keine Energie in das zweite Bordnetz abzugeben und/oder möglichst viel Energie aus dem zweiten Bordnetz T2 zu entnehmen. Der zweite Aspekt umfasst insbesondere auch das Einschalten von Verbrauchern.

Das Einleiten und Durchführen der aktiven Maßnahmen (Schritt 302b und 302c) bilden eine zweite Stufe (302) der Überspannungsschutzmaßnahme.

Als dritte Stufe der Überspannungsschutzmaßnahme wird in Schritt 303 das zweite Teilnetz T2 deaktiviert bzw. abgeschaltet und leistungslos geschaltet. Dazu erhält das Steuergerät S2 einen entsprechenden Befehl von der Überspannungsschutzschaltung 1 und steuert daraufhin den Schalter SW1 an und öffnet diesen.

## Patentansprüche

1. Überspannungsschutzschaltung (1) für ein erstes Teilnetz (T1) eines Mehrspannungsbordnetzes (100), das das erste Teilnetz (T1) mit einer ersten Bordspannung, ein zweites Teilnetz (T2) mit einer zweiten Bordspannung und eine elektrische Maschine (EM) zum Versorgen des zweiten Teilnetzes aufweist, wobei die erste Bordspannung geringer als die zweite Bordspannung ist,
mit einem ersten Masseanschluss (KL1) zum Anschließen eines gemeinsamen Massepotentials des ersten Teilnetzes (T1), des zweiten Teilnetzes (T2) und der elektrischen Maschine (EM), einem zusätzlichen zweiten Masseanschluss (KL2) zum Anschließen eines Referenzmassepotentials und einem Steueranschluss zum Ansteuern der elektrischen Maschine, **dadurch gekennzeichnet, dass** die Überspannungsschutzschaltung (1) dazu eingerichtet ist, zu überprüfen, ob eine Massedifferenzspannung zwischen dem ersten Masseanschluss (KL1) und dem zweiten Masseanschluss (KL2) einen Schwellwert erreicht und die zweite Bordspannung zu reduzieren, wenn die Massedifferenzspannung zwischen dem ersten Masseanschluss (KL1) und dem zweiten Masseanschluss (KL2) den Schwellwert erreicht.

2. Überspannungsschutzschaltung (1) nach Anspruch 1, wobei die Überspannungsschutzschaltung (1) ein passives Überspannungsschutzelement (10) aufweist, welches zwischen den ersten Masseanschluss (KL1) und den zweiten Masseanschluss (KL2) geschaltet ist.

3. Überspannungsschutzschaltung (1) nach Anspruch 1 oder 2, wobei die Überspannungsschutzschaltung (1) einen Komparator (OP) aufweist, der eingangsseitig mit dem ersten Masseanschluss (KL1) und mit den zweiten Masseanschluss (KL2) verbunden ist.

4. Überspannungsschutzschaltung (1) nach einem der vorstehenden Ansprüche, wobei die Überspannungsschutzschaltung (1) dazu eingerichtet ist, die von der elektrischen Maschine (EM) erzeugte Spannung zu reduzieren, wenn die Massedifferenzspannung zwischen dem ersten Masseanschluss (KL1) und dem zweiten Masseanschluss (KL2) den Schwellwert erreicht.

5. Überspannungsschutzschaltung (1) nach einem der vorstehenden Ansprüche, wobei die Überspannungsschutzschaltung (1) dazu eingerichtet ist, eine Verbindung zwischen dem zweiten Teilnetz (T2) und der elektrischen Maschine (EM) zu trennen (303), wenn die Massedifferenzspannung zwischen dem ersten Masseanschluss (KL1) und dem zweiten Masseanschluss (KL2) den Schwellwert erreicht.

6. Überspannungsschutzschaltung (1) nach einem der vorstehenden Ansprüche, mit einem Kommunikationsanschluss, der mit einer Kommunikationsleitung (CL) verbindbar ist, um Steuerbefehle an ein oder mehrere Komponenten (S2, V21, V22) für eine oder beide des ersten und des zweiten Teilnetzes auszugeben.

7. Überspannungsschutzschaltung (1) nach Anspruch 6, wobei der zweite Masseanschluss (KL2) Bestandteil des Kommunikationsanschlusses ist.

8. Mehrspannungsbordnetz (100) mit einem ersten Teilnetz (T1) mit einer ersten Bordspannung, einem zweiten Teilnetz (T2) mit einer zweiten Bordspannung, einer elektrischen Maschine (EM) zum Versorgen des zweiten Teilnetzes (T2), wobei die erste Bordspannung geringer als die zweite Bordspannung ist, und mit einer Überspannungsschutzschaltung (1) nach einem der vorstehenden Ansprüche, **dadurch gekennzeichnet, dass** der erste Masseanschluss (KL1) der Überspannungsschutzschaltung (1) an einem gemeinsamen Massepotential des ersten Teilnetzes (T1), des zweiten Teilnetzes (T2) und der elektrischen Maschine (EM) und der zweite Masseanschluss (KL2) an einem Referenzmassepotential angeschlossen ist.

9. Verfahren zum Schützen eines ersten Teilnetzes (T1) eines Mehrspannungsbordnetzes (100) vor Überspannung, wobei das Mehrspannungsbordnetzes (100) das erste Teilnetz (T1) mit einer ersten Bordspannung, ein zweites Teilnetz (T2) mit einer zweiten Bordspannung und eine elektrische Maschine (EM) zum Versorgen des zweiten Teilnetzes aufweist, wobei die erste Bordspannung geringer als die zweite Bordspannung ist, **dadurch gekennzeichnet, dass** die zweite Bordspannung reduziert wird, wenn eine Massedifferenzspannung zwischen einem gemeinsamen Massepotential des ersten Teilnetzes (T1), des zweiten Teilnetzes (T2) und der elektrischen Maschine (EM) und einem Referenzmassepotential einen Schwellwert erreicht.

10. Verfahren nach Anspruch 9, wobei die von der elektrischen Maschine (EM) erzeugte Spannung reduziert wird, wenn die Massedifferenzspannung den Schwellwert erreicht.

11. Verfahren nach Anspruch 10, wobei zwischen einem motorischen und einem generatorischen Betrieb der elektrischen Maschine (EM) gewechselt wird und/oder ein, insbesondere rollierender, Phasenkurzschluss der elektrischen Maschine durchgeführt wird, wenn die Massedifferenzspannung den Schwellwert erreicht.

12. Verfahren nach Anspruch 9, 10 oder 11, wobei eine Verbindung zwischen dem zweiten Teilnetz (T2) und der elektrischen Maschine (EM) getrennt wird (303), wenn die Massedifferenzspannung den Schwellwert erreicht.

13. Verfahren nach einem der Ansprüche 9 bis 12, wobei elektrische Verbraucher (V21, V22) in dem zweiten Teilnetz (T2) zum Spannungsabbau eingesetzt werden (302c).

14. Computerprogramm, das eine Recheneinheit dazu veranlasst, ein Verfahren nach einem der Ansprüche 9 bis 13 durchzuführen, wenn es auf der Recheneinheit ausgeführt wird.

15. Maschinenlesbares Speichermedium mit einem darauf gespeicherten Computerprogramm nach Anspruch 14.

## Claims

1. Overvoltage protection circuit (1) for a first subnetwork (T1) of a multi-voltage on-board electrical system (100), which has the first subnetwork (T1) having a first on-board electrical system voltage, a second subnetwork (T2) having a second on-board electrical system voltage, and an electric machine (EM) for the purpose of supplying the second subnetwork with power, wherein the first on-board electrical system voltage is lower than the second on-board electrical system voltage,
having a first earth connection (KL1) for the purpose of connecting a common earth potential of the first subnetwork (T1), of the second subnetwork (T2) and of the electric machine (EM), an additional second earth connection (KL2) for the purpose of connecting a reference earth potential, and a control connection for the purpose of driving the electric machine, **characterized in that**
the overvoltage protection circuit (1) is configured to check whether an earth differential voltage between the first earth connection (KL1) and the second earth connection (KL2) reaches a threshold value and to reduce the second on-board electrical system voltage when the earth differential voltage between the first earth connection (KL1) and the second earth connection (KL2) reaches the threshold value.

2. Overvoltage protection circuit (1) according to Claim 1, wherein the overvoltage protection circuit (1) has a passive overvoltage protection element (10), which is connected between the first earth connection (KL1) and the second earth connection (KL2).

3. Overvoltage protection circuit (1) according to Claim 1 or 2, wherein the overvoltage protection circuit (1) has a comparator (OP), the input side of which is connected to the first earth connection (KL1) and to the second earth connection (KL2).

4. Overvoltage protection circuit (1) according to one of the preceding claims, wherein the overvoltage protection circuit (1) is configured to reduce the voltage generated by the electric machine (EM) when the earth differential voltage between the first earth connection (KL1) and the second earth connection (KL2) reaches the threshold value.

5. Overvoltage protection circuit (1) according to one of the preceding claims, wherein the overvoltage protection circuit (1) is configured to disconnect (303) a connection between the second subnetwork (T2) and the electric machine (EM) when the earth differential voltage between the first earth connection (KL1) and the second earth connection (KL2) reaches the threshold value.

6. Overvoltage protection circuit (1) according to one of the preceding claims, having a communication connection, which can be connected to a communication line (CL), in order to output control commands to one or more components (S2, V21, V22) for one or both of the first and the second subnetworks.

7. Overvoltage protection circuit (1) according to Claim 6, wherein the second earth connection (KL2) is a constituent part of the communication connection.

8. Multi-voltage on-board electrical system (100) having a first subnetwork (T1) having a first on-board electrical system voltage, a second subnetwork (T2) having a second on-board electrical system voltage, an electric machine (EM) for the purpose of supplying the second subnetwork (T2) with power, wherein the first on-board electrical system voltage is lower than the second on-board electrical system voltage, and having an overvoltage protection circuit (1) according to one of the preceding claims, **characterized in that** the first earth connection (KL1) of the overvoltage protection circuit (1) is connected to a common earth potential of the first subnetwork (T1), of the second subnetwork (T2) and of the electric machine (EM) and the second earth connection (KL2) is connected to a reference earth potential.

9. Method for the protection of a first subnetwork (T1) of a multi-voltage on-board electrical system (100) against overvoltage, wherein the multi-voltage on-board electrical system (100) has the first subnetwork (T1) having a first on-board electrical system voltage, a second subnetwork (T2) having a second on-board electrical system voltage, and an electric machine (EM) for the purpose of supplying the second subnetwork with power, wherein the first on-board electrical system voltage is lower than the second on-board electrical system voltage, **characterized in that** the second on-board electrical system voltage is reduced when an earth differential voltage between a common earth potential of the first subnetwork (T1), of the second subnetwork (T2) and of the electric machine (EM) and a reference earth potential reaches a threshold value.

10. Method according to Claim 9, wherein the voltage generated by the electric machine (EM) is reduced when the earth differential voltage reaches the threshold value.

11. Method according to Claim 10, wherein operation of the electric machine (EM) switches between motor operation and generator operation and/or an, in particular rolling, phase short of the electric machine is carried out when the earth differential voltage reaches the threshold value.

12. Method according to Claim 9, 10 or 11, wherein a connection between the second subnetwork (T2) and the electric machine (EM) is disconnected (303) when the earth differential voltage reaches the threshold value.

13. Method according to one of Claims 9 to 12, wherein electrical consumers (V21, V22) in the second subnetwork (T2) are used (302c) for the purpose of voltage reduction.

14. Computer program, which causes a computing unit to carry out a method according to one of Claims 9 to 13 when it is executed on the computing unit.

15. Machine-readable storage medium having a computer program according to Claim 14 stored thereon.

## Revendications

1. Circuit de protection contre les surtensions (1) destiné à une première partie de réseau (T1) d'un réseau de bord à tensions multiples (100), lequel comprend la première partie de réseau (T1) présentant une première tension de bord, une seconde partie de réseau (T2) présentant une seconde tension de bord, et une machine électrique (EM) destinée à alimenter la seconde partie de réseau, dans lequel la première tension de bord est inférieure à la seconde tension de bord,
comportant un premier branchement de masse (KL1) permettant de connecter un potentiel de masse commun de la première partie de réseau (T1), de la seconde partie de réseau (T2) et de la machine électrique (EM), comportant un second branchement de masse (KL2) supplémentaire permettant de raccorder un potentiel de masse de référence et comportant un branchement de
commande permettant de commander la machine électrique, **caractérisé en ce que** le circuit de protection contre les surtensions (1) est conçu pour vérifier si une tension différentielle de masse entre le premier branchement de masse (KL1) et le second branchement de masse (KL2) atteint une valeur de seuil et pour réduire la seconde tension de bord lorsque la tension différentielle de masse entre le premier branchement de masse (KL1) et le second branchement de masse (KL2) atteint la valeur de seuil.

2. Circuit de protection contre les surtensions (1) selon la revendication 1, dans lequel le circuit de protection contre les surtensions (1) comporte un élément de protection contre les surtensions (10) passif qui est connecté entre le premier branchement de masse (KL1) et le second branchement de masse (KL2).

3. Circuit de protection contre les surtensions (1) selon la revendication 1 ou 2, dans lequel le circuit de protection contre les surtensions (1) comporte un comparateur (OP) qui est relié en entrée au premier branchement de mase (KL1) et au second branchement de masse (KL2).

4. Circuit de protection contre les surtensions (1) selon l'une quelconque des revendications précédentes, dans lequel le circuit de protection contre les surtensions (1) est conçu pour réduire la tension générée par la machine électrique (EM) lorsque la tension différentielle de masse entre le premier branchement de masse (KL1) et le second branchement de masse (KL2) atteint la valeur de seuil.

5. Circuit de protection contre les surtensions (1) selon l'une quelconque des revendications précédentes, dans lequel le circuit de protection contre les surtensions (1) est conçu pour séparer (303) une liaison entre la seconde partie de réseau (T2) et la machine électrique (EM) lorsque la tension différentielle de masse entre le premier branchement de masse (KL1) et le second branchement de masse (KL2) atteint la valeur de seuil.

6. Circuit de protection contre les surtensions (1) selon l'une quelconque des revendications précédentes, comportant un branchement de communication qui peut être relié à une ligne de communication (CL) afin de délivrer des instructions de commande à un ou plusieurs composants (S2, V21, V22) destinés à l'une des première et seconde parties de réseau ou aux deux.

7. Circuit de protection contre les surtensions (1) selon la revendication 6, dans lequel le deuxième branchement de masse (KL2) fait partie intégrante du branchement de communication.

8. Réseau de bord à tensions multiples (100) comportant une première partie de réseau (T1) présentant une première tension de bord, une seconde partie de réseau (T2) présentant une seconde tension de bord, une machine électrique (EM) destinée à alimenter la seconde partie de réseau (T2), dans lequel la première tension de bord est inférieure à la seconde tension de bord, et comportant un circuit de protection contre les surtension (1) selon l'une quelconque des revendications précédentes, **caractérisé en ce que** le premier branchement de masse (KL1) du circuit de protection contre les surtensions (1) est raccordé à un potentiel de masse commun de la première partie de réseau (T1), de la seconde partie de réseau (T2) et de la machine électrique (EM), et **en ce que** le second branchement de masse (KL2) est raccordé à un potentiel de masse de référence.

9. Procédé destiné à protéger une première partie de réseau (T1) d'un réseau de bord à tension multiples (100) contre une surtension, dans lequel le réseau de bord à tension multiples (100) comporte la première partie de réseau (T1) présentant une première tension de bord, une seconde partie de réseau (T2) présentant une seconde tension de bord et une machine électrique (EM) destinée à alimenter la deuxième partie de réseau, dans lequel la première tension de bord est inférieure à la seconde tension de bord, **caractérisé en ce que** la seconde tension de bord est réduite lorsque la tension différentielle de masse entre un potentiel de masse commun de la première partie de réseau (T1), de la seconde partie de réseau (T2) et de la machine électrique (EM) et un potentiel de masse de référence atteint une valeur de seuil.

10. Procédé selon la revendication 9, dans lequel la tension générée par la machine électrique (EM) est réduite lorsque la tension différentielle de masse atteint la valeur de seuil.

11. Procédé selon la revendication 10, dans lequel un basculement est effectué entre un fonctionnement de type moteur et un fonctionnement de type générateur de la machine électrique (EM) et/ou un court-circuit de phase, notamment tour à tour, de la machine électrique est effectué lorsque la tension différentielle de masse atteint la valeur de seuil.

12. Procédé selon la revendication 9, 10 ou 11, dans lequel une liaison entre la seconde partie de réseau (T2) et la machine électrique (EM) est séparée (303) lorsque la tension différentielle de masse atteint la valeur de seuil.

13. Procédé selon l'une quelconque des revendications 9 à 12, dans lequel des charges électriques (V21, V22) sont activées (302c) dans la seconde partie de réseau (T2) à des fins de réduction de la tension.

14. Programme d'ordinateur qui commande une unité de calcul afin qu'elle mette en oeuvre un procédé selon l'une quelconque des revendications 9 à 13, lorsqu'il est exécuté sur l'unité de calcul.

15. Support de stockage lisible par machine sur lequel est stocké un programme d'ordinateur selon la revendication 14.
